# EUROPÄISCHE PATENTSCHRIFT

(11) **EP 4 048 469 B1**
(45) Veröffentlichungstag und Bekanntmachung des Hinweises auf die Patenterteilung: **29.11.2023**
(21) Anmeldenummer: 20796714.2
(22) Anmeldetag: 14.10.2020
(51) Int. Cl.: B23K 1/00, B23K 1/008, B23K 3/08, H05K 13/00

(54) **TRANSPORTEINHEIT ZUM TRANSPORTIEREN VON LEITERPLATTEN UND LÖTANLAGE**
TRANSPORT UNIT FOR TRANSPORTING PRINTED CIRCUIT BOARDS, AND SOLDERING SYSTEM
UNITÉ DE TRANSPORT POUR TRANSPORTER DES CARTES DE CIRCUITS IMPRIMÉS ET INSTALLATION DE BRASAGE

(30) Priorität: 24.10.2019 DE 102019128780
(43) Veröffentlichungstag der Anmeldung: 31.08.2022
(73) Patentinhaber: Ersa GmbH, 97877 Wertheim (DE)
(72) Erfinder: RUPPERT, Elmar, 63875 Mespelbrunn (DE); HUHLER, Thomas, 97277 Neubrunn (DE); FLEISCHMANN, Benedict, 97277 Neubrunn (DE); HAME, Simon, 97892 Kreuzwertheim (DE)
(74) Vertreter: DREISS Patentanwälte PartG mbB
(86) Internationale Anmeldenummer: PCT/EP2020/078922
(87) Internationale Veröffentlichungsnummer: WO 2021/078606

(56) Entgegenhaltungen:
- US-A- 4 997 364
- US-A1- 2010 181 293
- US-A1- 2016 030 971

## Beschreibung

Die Erfindung betrifft eine Transporteinheit zum Transportieren von Leiterplatten entlang einer Transportrichtung innerhalb wenigstens einer Zone einer Lötanlage, wie beispielsweise einer Reflowlötanlage. Die Erfindung betrifft auch Lötanlagen, insbesondere Reflowlötanlagen, zum Durchlauflöten von Leiterplatten in einem Prozesskanal entlang einer Transportrichtung, wobei im Prozesskanal wenigstens eine Vorheizzone, wenigstens eine Lötzone und wenigstens eine Kühlzone vorgesehen sind, wobei in der Lötzone eine Druckkammer vorgesehen ist, die ein Basisteil und ein gegenüber dem Basisteil, im Betrieb der Reflowlötanlage anhebbares Deckelteil aufweist. Bei der Druckkammer handelt sich insbesondere um eine Unterdruckkammer; allerdings ist auch denkbar, dass die Druckkammer als Überdruckkammer ausgebildet ist.

Mittels derartigen Reflowlötanlagen werden insbesondere sogenannte SMD-Bauteile (Surface Mounted Devices) mittels Lotpaste auf die Oberfläche von Leiterplatten aufgelötet. Die Lotpaste, die insbesondere eine Mischung aus Lotmetallgranulat, Flussmittel und pastösen Bestandteilen ist, wird zum Reflowlöten auf die Oberfläche der Leiterplatten aufgetragen oder aufgedruckt. Anschließend werden die zu lötenden Bauteile in die Lotpaste gesetzt. Im Reflowlötprozess wird das Lötgut, also die Baugruppe bestehend aus Leiterplatte, Lotpaste und zu verlötenden Bauteilen, entlang des Prozesskanals in der Vorheizzone vorgewärmt und in der Lötzone auf eine Temperatur aufgeheizt, welche oberhalb des Schmelzpunktes der Lotpaste liegt. Dadurch schmilzt die Lotpaste und die Lötstellen bilden sich aus. In der Kühlzone wird das Lötgut abgekühlt, bis das aufgeschmolzene Lot erstarrt, bevor es aus der Reflowlötanlage entnommen wird.

Bei Reflowlötanlagen wird der Prozesskanal über eine Abdeckhaube abgedeckt, um im Prozesskanal das gewünschte Temperaturprofil und eine definierte Atmosphäre bereitstellen zu können. Ferner bilden sich im Prozesskanal Prozessgase, die aus dem Prozesskanal abgeführt und gereinigt werden können.

Zur Erzielung eines besseren Prozessergebnisses ist es bekannt, in der Lötzone eine Unterdruckkammer bzw. eine Vakuumkammer vorzusehen und derart einzurichten, dass der Lötprozess in der Vakuumkammer mit einem deutlich unterhalb des atmosphärischen Drucks liegenden Unterdruck erfolgt. Dadurch wird erreicht, dass Gas- und Luftblasen, Flussmittelüberreste und andere Verunreinigungen durch den Unterdruck während des Lötprozesses abgezogen werden, wodurch die Qualität der Lötverbindungen erhöht wird. Entsprechend kann die Qualität der Lötverbindungen durch Verwendung einer Überdruckkammer, innerhalb welcher der Lötprozess stattfindet, verbessert werden.

Aus der DE 10 2009 028 865 B4 und aus der US 2009/0014503 A1 sind Reflowlötanlagen mit Vakuumkammern bekannt. Aus der DE 201 02 064 U1 und aus der DE 199 11 887 C1 sind ebenfalls Reflowlötanlagen bekannt, welche eine Vakuumkammer vorsehen, die ein Basisteil und ein gegenüber dem Basisteil anhebbares Deckelteil in Form einer Vakuumglocke aufweisen. Zum Ein- und Ausfahren des Lötguts in die Vakuumkammer kann dabei das Deckelteil vom Basisteil angehoben werden.

Ferner ist aus der US 4 844 231 A ein zweiteiliges Fördersystem bekannt, wobei eine Antriebseinheit zum Antreiben von Produktionsteilen über Riemen mit Förderrollen verbunden ist. In der DE 199 00 461 A1 ist eine Transportvorrichtung für Transportbehälter offenbart, wobei die Kraftübertragung durch Zahnräder erfolgen kann. Aus der US 4 997 364 A (Basis für den Oberbegriff des Anspruchs 1) und der US 2010/018293 A1 ist eine Transporteinheit mit einem Riemenförderer bekannt. Die US 2016/0030971 A1 offenbart eine Transporteinheit mit einem Riemenrad.

Der Erfindung liegt die Aufgabe zugrunde, eine eingangs Transporteinheit bereitzustellen, die insbesondere in einer Druckkammer der Lötanlage Verwendung finden kann und die vorteilhafte Eigenschaften aufweist.

Diese Aufgabe wird gelöst durch eine Transporteinheit mit den Merkmalen des Patentanspruchs 1. Dabei ist folglich insbesondere vorgesehen, dass ein Grundteil mit einer von insbesondere einem Drehantrieb antreibbaren Abtriebswelle und wenigstens zwei mit der Abtriebswelle drehgekoppelte Abtriebsräder vorgesehen ist, dass wenigstens zwei am Grundteil lösbar befestigbare und abnehmbare Antriebsteile mit jeweils einem Antriebsrad derart vorgesehen sind, dass die Antriebsteile mit dem jeweiligen Antriebsrad drehgekoppelte Antriebsrollen aufweisen, die zum Transportieren der Leiterplatte durch die Zone gegen die Leiterplatte wirken, und dass bei am Grundteil befestigtem Antriebsteil das jeweilige Abtriebsrad mit dem zugehörigen Antriebsrad in Eingriff steht. Bei vom Grundteil abgenommenem Antriebsteil ist folglich das Antriebsrad nicht mehr in Eingriff mit dem Abtriebsrad. Das Antriebsrad und das Abtriebsrad sind dabei als Zahnräder ausgebildet.

Ferner sind am Grundteil sich in Transportrichtung erstreckende Aufnahmeteile zur Aufnahme und zum lösbaren Befestigen der Antriebsteile vorgesehen, wobei die Aufnahmeteile jeweils ein mit dem Antriebsrad in Eingriff bringbare und von der Abtriebswelle antreibbare Abtriebsrad aufweisen. Das jeweilige Antriebsteil kann folglich auf ein zugehöriges Aufnahmeteil aufgesetzt werden bzw. vom zugehörigen Aufnahmeteil abgenommen werden. Vorzugsweise ist eine Befestigungsvorrichtung vorgesehen, mittels derer die Antriebsteile an den jeweiligen Aufnahmeteilen befestigt werden können. Denkbar ist, dass eine insbesondere händisch betätigbare Verschraubung vorgesehen ist.

Eine derartige Transporteinheit hat den Vorteil, dass die Antriebsteile auf einfache Art und Weise ausgetauscht werden können. Zum Lösen der Drehkopplung zwischen Abtriebsrad und Antriebsrad ist lediglich das Antriebsteil vom Grundteil abzunehmen, wodurch das Antriebsrad vom Abtriebsrad abhebt. Bei auf das Grundteil aufgesetztem Antriebsteil ist das Antriebsrad mit dem Abtriebsrad in direktem Eingriff. Das Abnehmen der Antriebsteile ist deshalb erforderlich, da diese regelmäßig kontrolliert, gereinigt, gewartet und ggf. Instand gesetzt werden müssen. Insbesondere dann, wenn die Transporteinheit in einer Druckkammer der Reflowlötanlage Verwendung findet, ist sie hohen Temperaturen und hohen mechanischen Belastungen ausgesetzt. Die einfache Entnehmbarkeit der Antriebsteile und das Austauschen der Antriebsteile senkt die Stillstandzeiten der Reflowlötanlage und erhöht damit deren Produktivität.

Vorteilhafterweise sehen die Antriebsteile eine Vielzahl von in Transportrichtung hintereinander angeordneten Antriebsrollen vor, wobei jeweils benachbarte Antriebsrollen über Zahnräder miteinander drehgekoppelt sind und wobei wenigstens eines der Zahnräder mit dem Antriebsrad drehgekoppelt ist. Durch Vorsehen von mehreren hintereinander angeordneten Antriebsrollen kann ein sicheres Transportieren der Leiterplatten durch die jeweilige Zone gewährleistet werden. Dadurch, dass die einzelnen Antriebsrollen über Zahnräder miteinander drehgekoppelt sind, findet keine Gleitbewegung zwischen den Bauteilen statt, wodurch die Transporteinheit vergleichsweise wartungsarm ist und vergleichsweise wenig Schmierstoffe benötigt werden. Zudem weisen die Antriebsteile eine hohe Robustheit auf, insbesondere können sie als solche leicht entnommen, ausgetauscht und/oder gereinigt werden.

Das Grundteil ist vorteilhafterweise rahmenartig mit zwei sich in Transportrichtung erstreckenden Seitenteilen und mit zwei sich in quer zur Transportrichtung verlaufender Querrichtung erstreckenden Holmen ausgebildet. Ein derartiges Grundteil kann vorzugsweise auf einfache Art und Weise aus der jeweiligen Zone der Lötanlage entnommen werden, um bei Bedarf die gesamte Transporteinheit auszutauschen, zu reinigen oder zu warten. Insbesondere dann, wenn die Transporteinheit innerhalb einer Druckkammer der Lötanlage zum Einsatz kommt, hat sich dies bewährt.

Die Antriebswelle erstreckt sich vorzugsweise in Querrichtung und ist an den beiden Seitenteilen drehgelagert angeordnet. Dadurch ist es möglich, dass die Antriebswelle mehrere, zwischen den Seitenteilen vorgesehene Antriebsteile, bzw. deren Antriebsräder und Antriebsrollen antreibt.

Zudem ist vorteilhaft, wenn wenigstens ein Aufnahmeteil, und wenn vorzugsweise mehrere Aufnahmeteile in Querrichtung auf den Holmen beweglich verstellbar angeordnet sind. Durch eine derartige Verstellung in Querrichtung kann eine Anpassung an die sich in Querrichtung erstreckende Breite der Leiterplatten erfolgen. Je nach Breite der zu verlötenden Leiterplatte kann folglich eine entsprechende Verstellung der Aufnahmeteile, und damit auch der Antriebsteile bewirkt werden. Hierzu kann zwischen den Aufnahmeteilen und den Holmen eine geeignete Lagerung vorgesehen sein, beispielsweise eine Gleitlagerung oder eine Lagerung mittels Wälzlagern.

Ferner ist vorteilhaft, wenn die Aufnahmeteile jeweils ein Koppelrad vorsehen, das zum einen mit dem Antriebsrad und zum anderen mit der Abtriebswelle drehgekoppelt ist. Das Koppelrad ist dabei vorzugsweise auf der Abtriebswelle axial verschiebbar angeordnet, so dass ein Verschieben und Verstellen des Aufnahmeteils in Querrichtung ermöglicht ist, wobei zugleich eine Drehkopplung zwischen der Abtriebswelle und dem Koppelrad gewährleistet wird. Dabei ist denkbar, dass die Abtriebswelle einen nicht kreisförmigen Querschnitt aufweist, und beispielsweise als Kantwelle, und insbesondere als Vier-oder Sechskantwelle ausgebildet ist. Das Koppelrad weist dann eine zur Außenkontur der Antriebswelle komplementäre Aufnahmekontur auf, so dass das Koppelrad auf der Abtriebswelle verschieblich angeordnet ist, aber dennoch mit ihr drehgekoppelt ist.

Ferner hat sich als vorteilhaft erwiesen, wenn wenigstens eine sich in Querrichtung erstreckende Verstellwelle vorgesehen ist, die derart mit wenigstens einem Aufnahmeteil gekoppelt ist, dass das Aufnahmeteil durch Verdrehen der Verstellwelle in Querrichtung verlagerbar ist. Die Verstellwelle kann dabei insbesondere als Spindelwelle ausgebildet sein, wobei dann das jeweilige Aufnahmeteil eine mit der Spindelwelle zusammenwirkende Spindelmutter aufweist. Durch Verdrehen der Spindelwelle kann dadurch das jeweilige Aufnahmeteil in Querrichtung verstellt werden. Vorteilhafterweise ist die Verstellwelle, entsprechend der Abtriebswelle, an den Seitenteilen des Grundteils drehbar gelagert angeordnet. Weiter ist die Spindelmutter in sich verdrehbar um das Lagerspiel zwischen Breitenverstellwelle und Spindelmutter einstellen zu können bzw. durch Verschleiß bedingtes Spiel später im Betrieb ausgleichen zu können.

Eine bevorzugte Ausführungsform sieht zwei Rand-Aufnahmeteile zur Aufnahme von jeweils einem Rand-Antriebsteil auf, wobei die Antriebsrollen des einen Rand-Antriebsteils den Antriebsrollen des anderen Rand-Antriebsteils zugewandt und so angeordnet sind, dass sie im Betrieb der Transporteinheit die Leiterplatte im Bereich ihrer freien Längskanten auf den jeweiligen Antriebsrollen aufliegt. Im Bereich der freien Längskanten sind bei den Leiterplatten in der Regel keine elektronischen Bauteile vorgesehen, so dass hier die Antriebsrollen vorteilhaft an der Leiterplatte zu deren Transport angreifen können.

Ferner ist vorteilhaft, wenn die Rand-Antriebsteile Längsführungen zur Führung der Leiterplatten in Transportrichtung vorsehen. Die Längsführungen wirken im Betrieb dann gegen die freien Kanten der Leiterplatten, so dass diese sicher in Transportrichtung durch die Lötanlage hindurchgeführt werden können.

Weiterhin ist vorteilhaft, wenn zwischen den beiden Rand-Aufnahmeteilen wenigstens ein Mitten-Aufnahmeteil zur Aufnahme von einem Mitten-Antriebsteil vorgesehen ist. Ein derartiges Mitten-Antriebsteil bildet dann eine Mitten-Unterstützung, die insbesondere dann notwendig ist, wenn vergleichsweise große Leiterplatten verlötet werden sollen. Das Mitten-Antriebsteil verhindert ein Durchbiegen oder Durchhängen der Leiterplatte in ihrem mittleren Bereich und gewährleistet zudem einen funktionssicheren Transport.

Zudem ist vorteilhaft, wenn die Transporteinheit zwei in Transportrichtung verlaufende Transportspuren aufweist, wobei für jede Transportspur jeweils zwei Rand-Aufnahmeteile und ggf. zusätzlich zwischen den jeweils Rand-Aufnahmeteilen ein Mitten-Aufnahmeteil vorgesehen ist. Hierdurch kann insgesamt die Kapazität der Transporteinheit und dadurch auch der gesamten Lötanlage erhöht werden.

Dabei ist vorteilhaft, wenn mehrere Verstellwellen vorgesehen sind, zum einen eine Verstellwelle zum Verstellen der Rand-Aufnahmeteile und eine weitere Verstellwelle zum Verstellen der Mitten-Aufnahmeteile. Dadurch kann insgesamt eine Breitenverstellung der jeweiligen Transportspur auf einfache Art und Weise erfolgen.

Die genannte Aufgabe wird auch gelöst durch eine eingangs genannte Lötanlage, insbesondere eine Reflow-Lötanlage, die sich dadurch auszeichnet, dass wenigstens in einer der Zonen und/oder in der Druckkammer eine erfindungsgemäße Transporteinheit vorgesehen ist. Wie bereits erwähnt, ist es bevorzugt, eine solche Transporteinheit in der Druckkammer vorzusehen, da zum einen die Antriebsteile der Transporteinheit auf einfache Art und Weise austauschbar sind und zum anderen die Transporteinheit als solche ebenfalls auf einfache Art und Weise austauschbar ist.

Weitere Einzelheiten und vorteilhafte Ausgestaltungen der Erfindung sind der nachfolgenden Beschreibung zu entnehmen, anhand derer ein Ausführungsbeispiel der Erfindung näher beschrieben und erläutert ist.

Es zeigen:
- Figur 1: eine Reflowlötanlage in Seitenansicht;
- Figur 2: die Reflowlötanlage gemäß Figur 1 in Vorderansicht;
- Figur 3: die Draufsicht auf die Lötzone der Reflowlötanlage ohne Abdeckhaube;
- Figur 4: eine perspektivische Ansicht einer zweispurigen Transporteinheit;
- Figur 5: die Transporteinheit gemäß Figur 4 ohne seitliche Abdeckung und ohne Seitenteil;
- Figur 6: Einzelteile der Transporteinheit gemäß Figur 4 mit einem abgenommenen Antriebsteil;
- Figur 7: eine Ansicht auf ein an einem Aufnahmeteil befestigten Antriebsteil.

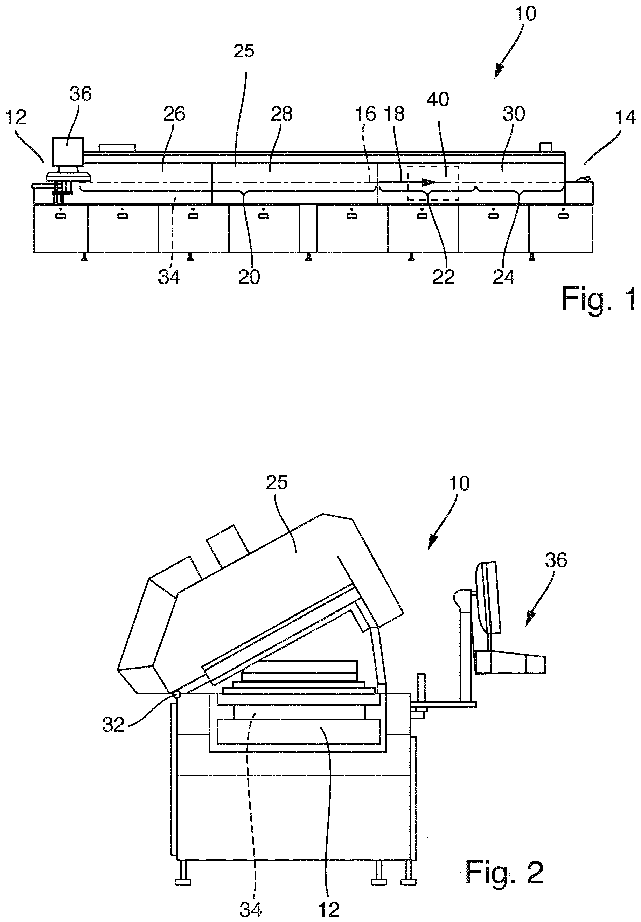

In der Figur 1 ist eine Reflowlötanlage 10 zum Durchlauflöten von Lötgut dargestellt. Die Reflowlötanlage 10 weist einen Eingang 12 und einen Ausgang 14 auf, wobei das zu lötende Lötgut über den Eingang 12 in die Reflowlötanlage 10 gelangt und über den Ausgang 14 aus der Reflowlötanlage 10 abgeführt wird. Das Lötgut wird dabei entlang einer Transportrichtung 18 eines in Figur 1 angedeuteten Prozesskanals 16 durch die Reflowlötanlage 10 transportiert.

Im Prozesskanal 16 ist eine Vorheizzone 20, eine Lötzone 22 und eine Kühlzone 24 vorgesehen. Bei der in der Figur 1 gezeigten Reflowlötanlage 10 ist eine Maschinenverkleidung 25 mit drei Abschnitten 26, 28 und 30 zur Abdeckung des Prozesskanals 16 vorgesehen.

Wie aus den Figuren 1 und 2 deutlich wird, ist eine Kommunikationseinheit 36 mit einem Bildschirm und einer Eingabeeinrichtung vorgesehen, mittels welcher mit einer Maschinensteuerung der Reflowlötanlage 10 kommuniziert werden kann.

Das Lötgut, also die mit Lotpaste versehene und mit elektronischen Bauteilen bestückte Leiterplatte, wird zunächst in der Vorheizzone 20 aufgeheizt, auf eine Temperatur, die unterhalb der Schmelztemperatur der Lotpaste liegt. In der Lötzone 22 wird die Leiterplatte für eine bestimmte Dauer auf eine Prozesstemperatur erwärmt, welche oberhalb des Schmelzpunktes der Lotpaste liegt, so dass diese in der Lötzone schmilzt, um die elektronischen Bauteile mit der Leiterplatte zu verlöten. In der Kühlzone 24 wird das Lötgut abgekühlt, so dass das flüssige Lot erstarrt, bevor das Lötgut am Ausgang 14 der Reflowlötanlage 10 entnommen wird.

Zum Transportieren der Leiterplatten entlang der Transportrichtung 18 ist innerhalb der Reflowlötanlage 10 ein Transportsystem 34 vorgesehen.

Wie aus der Vorderansicht der Figur 2 deutlich wird, kann die Abdeckhaube 25 um eine sich parallel zur Transportrichtung 18 erstreckende Schwenkachse 32 aufgeschwenkt werden. Durch Aufschwenken der Abdeckhaube 25 ist das Transportsystem 34 zugänglich, um dieses optisch zu kontrollieren, zu warten, zu reinigen, einzurichten, auszutauschen und gegebenenfalls zu reparieren.

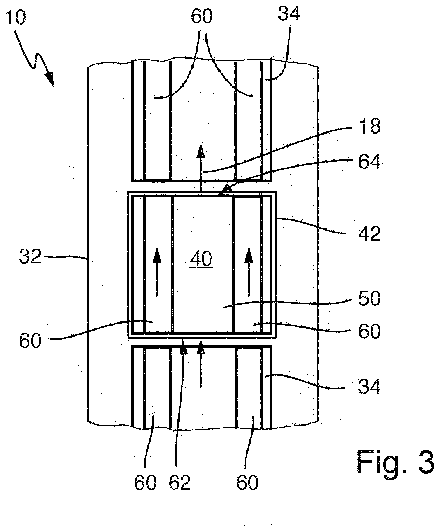

In der Lötzone 22 befindet sich eine Druckkammer in Form einer Unterdruckkammer 40, die von einem in der Draufsicht gemäß Figur 3 gezeigten Basisteil 42 und einem nicht in den Figuren gezeigten Deckelteil, mit dem das Basisteil 42 verschlossen werden kann, gebildet wird.

Im Betrieb der Reflowlötanlage 10 kann das Deckelteil mittels einem Hubmechanismus vom Basisteil 42 abgehoben werden. Ein Abheben des Deckelteils ist erforderlich, um die Leiterplatten in die Unterdruckkammer 40 einfahren zu können. Sobald sich die Leiterplatten in der Unterdruckkammer 40 befinden, wird das Deckelteil abgesenkt, so dass es auf dem Basisteil 42 zum Aufliegen kommt. In einem nächsten Schritt wird mit einer nicht dargestellten Unterdruckpumpe die Unterdruckkammer 40 evakuiert, so dass in der Unterdruckkammer 40 ein geeigneter Unterdruck entsteht. Aufgrund des Unterdrucks werden insbesondere Lufteinschlüsse in dem flüssigen Lot ausgetrieben. Nach kurzer Unterdruckbeaufschlagung der Unterdruckkammer 40 wird das Deckelteil über eine entsprechende Ansteuerung des Hubmechanismus angehoben, so dass die Leiterplatten aus der Unterdruckkammer 40 herausfahren kann. Vorteilhafterweise bewegen sich die Leiterplatten innerhalb des beschriebenen Prozesses mit konstanter oder mit veränderbarer Geschwindigkeit durch die Unterdruckkammer 40 hindurch.

In der Draufsicht gemäß Figur 3 ist das Basisteil 42 der Druckkammer 40 sowie die in dem Basisteil 42 vorgesehene Transporteinheit 50 schematisch dargestellt. Insgesamt sind zwei parallel zueinander verlaufende Transportspuren 60 vorgesehen, entlang welchen Leiterplatten nebeneinander entlang der Transportrichtung 18 durch die Prozesskammer 16 und die Unterdruckkammer 40 transportiert werden können. Die Unterdruckkammer 40 sieht einen Kammereingang 62, in dem vom Transportsystem 34 kommende Leiterplatten der Transporteinheit 50 übergeben werden, und einen Kammerausgang 64, in dem die Leiterplatten wieder dem Transportsystem 34 übergeben werden, vor.

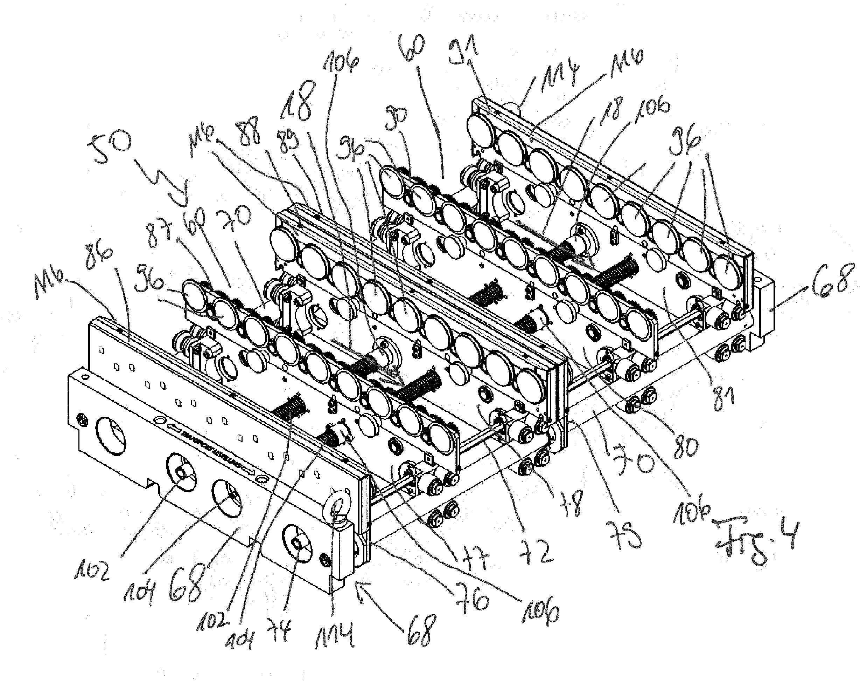

In der Figur 4 ist die Transporteinheit 50, welche in die Druckkammer 40, bzw. in das Basisteil 42 der Druckkammer 40 einsetzbar ist, gezeigt. Bei den in der Figur 3 angedeuteten Transportsystemen 34 kann es sich um Transportsysteme handeln, welche der Transporteinheit 50 entsprechen. Allerdings ist auch denkbar, dass dort andersartig ausgebildete Transportsysteme zum Einsatz kommen, da diese Transportsysteme 34 einer geringeren Beanspruchung unterliegen, als die Transporteinheit 50, welche innerhalb der Druckkammer 40 zum Einsatz kommt.

Die Transporteinheit 50 umfasst ein Grundteil 66, welches rahmenartig ausgebildet ist und zwei sich in Transportrichtung 18 erstreckende Seitenteile 68 sowie zwei in Querrichtung verlaufende Holme 70 aufweist. Am Grundteil 66 ist ferner eine an den Seitenteilen 68 drehbar gelagerte Abtriebswelle 72 vorgesehen, die an ihrem freien Ende 74 über einen nicht näher dargestellten Drehantrieb angetrieben werden kann.

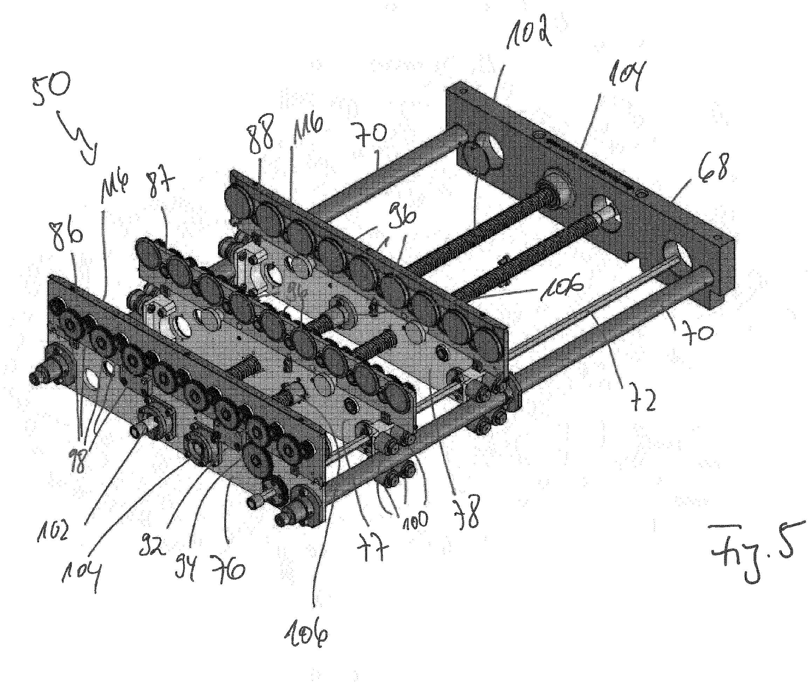

Am Grundteil 66 sind zwischen den Seitenteilen 68 insgesamt sechs Aufnahmeteile 76 bis 81 vorgesehen, auf welchen lösbar befestigbare und abnehmbare Antriebsteile 86 bis 91 vorgesehen sind. In der Figur 5 ist das Transportsystem 50 mit lediglich nur einem Seitenteil 68 und lediglich mit den drei Aufnahmeteilen 76 bis 78 sowie den drei Antriebsteilen 86 bis 88 gezeigt.

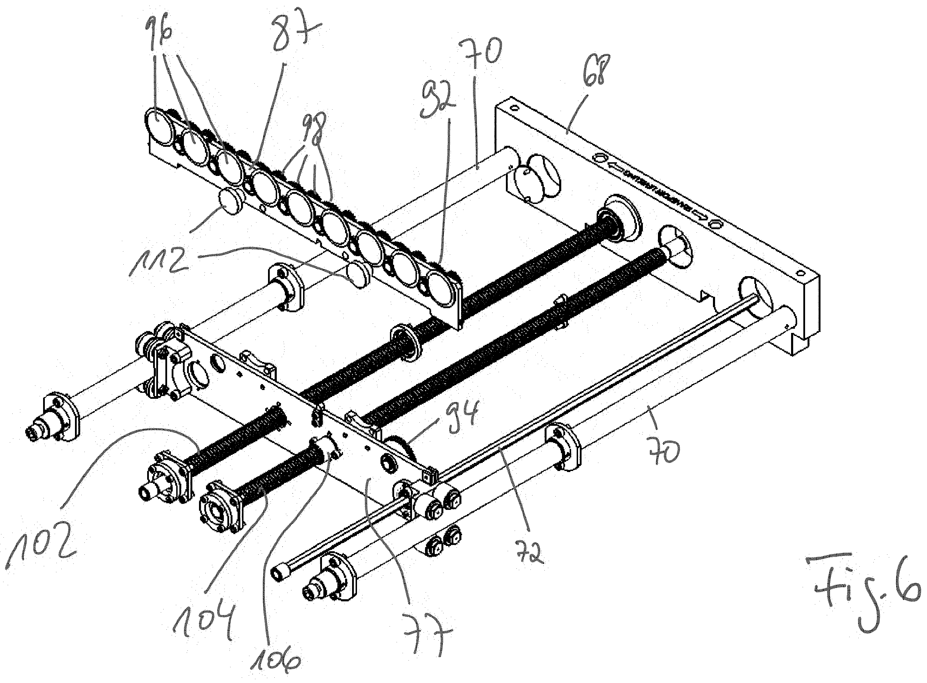

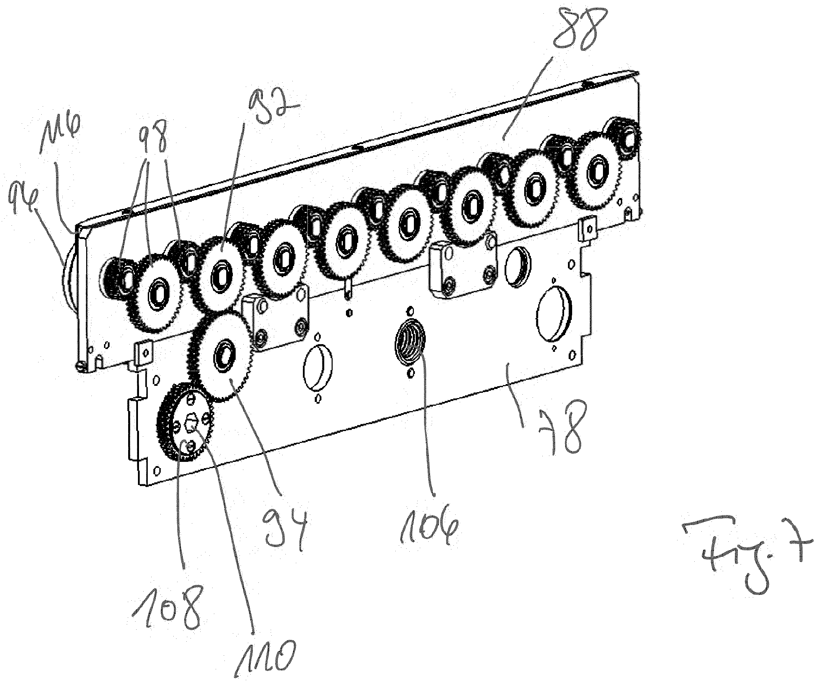

Die Antriebsteile 86 bis 91 weisen jeweils ein Antriebsrad 92 auf, welches im montierten Zustand, wie insbesondere aus Figur 5 und 7 deutlich wird, mit jeweils einem Abtriebsrad 94, welches am Grundteil 68 bzw. an den jeweiligen Aufnahmeteilen 76 bis 81 vorgesehen ist, im Eingriff steht. Die Antriebsräder 92 sowie die Abtriebsräder 94 sind koaxial zueinander sowie koaxial zur Abtriebswelle 72 und zu den Holmen 70 angeordnet. Die Anordnung ist dabei derart, dass bei abgenommenen Antriebsteilen 86 bis 91, wie es in Figur 6 gezeigt ist, das jeweilige Antriebsrad 92 vom jeweiligen Abtriebsrad 94 abgehoben wird und damit nicht mehr in Eingriff mit dem jeweiligen Abtriebsrad 94 steht.

Die jeweiligen Antriebsteile 86 bis 91 weisen ferner mit dem jeweils zugehörigen Antriebsrad 92 drehgekoppelte Antriebsrollen 96 auf, auf welchen die Leiterplatten im Betrieb zum Aufliegen kommen und welche die Leiterplatten durch die jeweilige Zone 18, 20, 22 bzw. durch die Druckkammer 40 transportieren. Wie ferner aus den Figuren 4, 5 und 6 deutlich wird, sind an den Antriebsteilen 86 bis 91 eine Vielzahl von in Transportrichtung 18 hintereinander angeordneten Antriebsrollen 96 vorgesehen, wobei jeweils benachbarte Antriebsrollen 96 über Zahnräder 98 miteinander drehgekoppelt sind. Dabei bildet eines dieser Zahnräder das Antriebsrad 92, welches, wie aus Figur 7 deutlich wird, im montierten Zustand mit dem Abtriebsrad 94 in Eingriff steht.

Mit der Transporteinheit 50 können, wie zu Figur 3 erläutert, Leiterplatten entlang den beiden Transportspuren 60 transportiert werden. Der einen Transportspur 60 sind dabei die Aufnahmeteile 76, 77 und 78 mit den Antriebsteilen 86, 87 und 88 zugeordnet. Der zweiten Transportspur 60 sind die Aufnahmeteile 79, 80, 81 mit den Antriebsteilen 89, 90, 91 zugeordnet.

In der Figur 5 sind die Aufnahmeteile 76, 77, 78 und die Antriebsteile 86, 87, 88 von lediglich einer Transportspur 60 gezeigt. Die Aufnahmeteile 76, 78 sind dabei als Rand-Aufnahmeteile und das mittlere Aufnahmeteil 77 als Mitten-Aufnahmeteil ausgebildet. Die Antriebsteile 86, 88 sind dabei als Rand-Antriebsteile und das mittlere Antriebsteil 87 als Mitten-Antriebsteil ausgebildet. Die Rand-Aufnahmeteile 76, 78 dienen zur Aufnahme der Rand-Antriebsteile 86, 88 und das Mitten-Aufnahmeteil 77 dient zur Aufnahme des Mitten-Antriebsteil 87. Die Anordnung ist dabei derart, dass die Antriebsrollen 96 der Rand-Antriebsteile 86, 88 einander zugewandt angeordnet sind, so dass im Betrieb der Transporteinheit 50 die jeweilige Leiterplatte im Bereich ihrer freien Längskanten auf den jeweiligen Antriebsrollen 96 zum Aufliegen kommt. Die Rand-Antriebsteile 86, 88 und 89, 91 weisen Längsführungen 116 auf, welche zur Führung der Leiterplatten im Betrieb der Anlage in Transportrichtung 18 dienen. Zur Abstützung der Leiterplatten im Mittenbereich ist das Mitten-Antriebsteil 87 vorgesehen, welches die Leiterplatten-Mittenbereiche zusätzlich antreibt.

Die Aufnahmeteile 79, 80 und 81 und die zugehörigen Antriebsteile 89, 90 und 91, welche die zweite Transportspur 60 bilden, entsprechen dabei im Aufbau den Aufnahmeteilen 76, 77, 78 und Antriebsteilen 86, 87, 88 der ersten Transportspur 60.

Um die Breite der jeweiligen Transportspur 60, bzw. die Position der Antriebsteile 86 bis 91 in Querrichtung verstellen zu können, sind die Aufnahmeteile 78 bis 81 mittels Führungsrollen 100 auf den Holmen 70 verfahrbar angeordnet. Zum Verstellen der Aufnahmeteile 76 bis 81 sind zwei an den Seitenteilen 68 drehbar gelagerte Spindelwellen 102 und 104 vorgesehen, welche über in den Figuren nicht dargestellte Drehantriebe antreibbar sind. Die Spindelwelle 102 ist dabei mit den Rand-Aufnahmeteilen 78 und 81 über Spindelmuttern 106 bewegungsgekoppelt, so dass bei einer Verdrehung der Spindelwelle 102 die beiden Aufnahmeteile 78 und 81, und damit die Antriebsteile 88 und 91 verstellbar sind. Die Spindelwelle 104 ist über Spindelmuttern mit den Mitten-Aufnahmeteilen 77 und 80 bewegungsgekoppelt, so dass beim Verdrehen der Spindelwelle 104 die Aufnahmeteile 77 und 80, und damit die Antriebsteile 87 und 90 in Querrichtung verstellbar sind.

Um eine Drehkopplung der Abtriebsräder 94 mit der Abtriebswelle 72 auch bei Verstellung der Aufnahmeteile 76 bis 81 in Querrichtung zu ermöglichen, weisen die Aufnahmeteile 76 bis 81 mit den Abtriebsrädern 94 drehgekoppelte Koppelräder 108 auf, was insbesondere aus Figur 7 deutlich wird. Die Koppelräder 108 weisen jeweils eine Aufnahmekontur 110 auf, die komplementär zum Querschnitt der Abtriebswelle 72 ist, so dass die Koppelräder 108 und damit die zugehörigen Aufnahmeteile 76 bis 81 mit den Antriebsteilen 89 bis 91 auf der Abtriebswelle 72 in Querrichtung verschiebbar und dennoch mit der Abtriebswelle 72 drehgekoppelt sind. Bei der in den Figuren gezeigten Ausführungsform weist die Abtriebswelle 72 einen Sechskant-Querschnitt auf, wobei die an den jeweiligen Koppelrädern 108 vorgesehene Aufnahmekontur 110 als Sechskant-Ausnahme ausgebildet ist.

Wie aus Figur 6 deutlich wird, können die Antriebsteile 86 bis 91 von den zugehörigen Aufnahmeteilen 76 bis 81 auf einfache Art und Weise nach vertikal oben entnommen werden. Dazu müssen lediglich Befestigungsmittel, die in der Figur 6 als handbetätigte Befestigungsschrauben 112 ausgebildet sind, gelöst werden. Nach dem Lösen der Befestigungsschrauben 112 und dem Entfernen des jeweiligen Antriebsteils 86 bis 91 hebt auch das jeweilige Antriebsrad 92 zum zugehörigen Abtriebsrad 94 ab. Beim erneuten Aufsetzen des jeweiligen Antriebsteils 86 bis 91 auf das jeweils zugehörige Aufnahmeteil 76 bis 81 kommt das jeweilige Antriebsrad 92 wieder in Eingriff mit dem zugehörigen Abtriebsrad 94.

Wie aus Figur 4 deutlich wird, sind am Rahmen Halteösen 114 vorgesehen, über welche die gesamte Transporteinheit 50 aus der Lötanlage 10, bzw. aus der entsprechenden Zone 20, 22, 24 oder der Druckkammer 40 auf einfache Art und Weise entnommen werden kann.

Die beschriebene Reflowlötanlage 10, bzw. die beschriebene Antriebseinheit 50 hat den Vorteil, dass die einzelnen Antriebsteile 86 bis 91 auf einfache Art und Weise ausgetauscht, inspiziert, gewartet und gereinigt werden können. Ferner kann die gesamte Transporteinheit 50 ebenfalls ausgetauscht werden. Die beschriebenen Antriebsteile 86 bis 91 sind vergleichsweise robust, da lediglich Zahnräder und keine Ketten oder Riemen zum Einsatz kommen. Ferner kann auch auf eine intensive und / oder automatische Schmierung verzichtet werden. Auch für Verschmutzungen in Form von Kondensat oder Lotreste ist die Ausführung mit Zahnrädern deutlicher weniger empfindlich. Desweiteren ist, im Vergleich zu konventionellen Antrieben mit Kette, keine Kettenspanneinrichtung nötig.

## Patentansprüche

1. Transporteinheit (50) zum Transportieren von Leiterplatten entlang einer Transportrichtung (18) innerhalb wenigstens einer Zone einer Lötanlage (10), insbesondere einer Reflowlötanlage, wobei ein Grundteil (68) mit einer antreibbaren Abtriebswelle (72) vorgesehen ist, **dadurch gekennzeichnet, dass** wenigstens zwei mit der Abtriebswelle (72) drehgekoppelte Abtriebszahnräder (94) vorgesehen sind, dass wenigstens zwei am Grundteil (68) lösbar befestigbare und abnehmbare Antriebsteile (86 bis 91) mit jeweils einem Antriebszahnrad (92) derart vorgesehen sind, dass die Antriebsteile (86 bis 91) mit dem Antriebszahnrad (92) drehgekoppelte Antriebsrollen (96) aufweisen, die zum Transportieren der Leiterplatte durch die Zone gegen die Leiterplatte wirken, dass bei am Grundteil (68) befestigten Antriebsteilen (86 bis 91) das jeweilige Abtriebszahnrad (94) mit dem zugehörigen Antriebszahnrad (92) in Eingriff steht, und dass am Grundteil (68) sich in Transportrichtung (18) erstreckende Aufnahmeteile (76 bis 81) zur Aufnahme und zum lösbaren Befestigen der Antriebsteile (86 bis 91) vorgesehen sind, wobei die Aufnahmeteile (76 bis 81) jeweils das mit dem Antriebszahnrad (92) in Eingriff bringbare und von der Abtriebswelle (72) antreibbare Abtriebszahnrad (94) aufweisen.

2. Transporteinheit (50) nach Anspruch 1, **dadurch gekennzeichnet, dass** die Antriebsteile (86 bis 91) eine Vielzahl von in Transportrichtung (18) hintereinander angeordneten Antriebsrollen (96) aufweisen, wobei jeweils benachbarte Antriebsrollen (96) über Zahnräder (98) miteinander drehgekoppelt sind und wobei wenigstens ein Zahnrad (98) mit dem Antriebszahnrad (92) drehgekoppelt ist.

3. Transporteinheit (50) nach Anspruch 1 oder 2, **dadurch gekennzeichnet, dass** das Grundteil (68) rahmenartig mit zwei sich in Transportrichtung (18) erstreckenden Seitenteilen (68) und mit zwei sich in quer zur Transportrichtung (18) verlaufender Querrichtung erstreckenden Holmen (70) ausgebildet ist.

4. Transporteinheit (50) nach Anspruch 3, **dadurch gekennzeichnet, dass** die Anordnung derart ist, dass der Rahmen lösbar und entfernbar in der Lötanlage (10) anordenbar ist.

5. Transporteinheit (50) nach Anspruch 3 oder 4, **dadurch gekennzeichnet, dass** sich die Abtriebswelle (72) in Querrichtung erstreckt und an den beiden Seitenteilen drehgelagert angeordnet ist.

6. Transporteinheit (50) nach Anspruch 3, **dadurch gekennzeichnet, dass** wenigstens ein Aufnahmeteil (76 bis 81) in Querrichtung auf den Holmen (70) beweglich und verstellbar angeordnet ist.

7. Transporteinheit (50) nach Anspruch 6, **dadurch gekennzeichnet, dass** die Aufnahmeteile (76 bis 81) jeweils ein Koppelzahnrad (108) vorsehen, das mit dem Abtriebszahnrad (94) und mit der Abtriebswelle (72) drehgekoppelt und auf der Abtriebswelle (72) axial verschiebbar angeordnet ist.

8. Transporteinheit (50) nach Anspruch 6oder 7, **dadurch gekennzeichnet, dass** wenigstens eine sich in Querrichtung erstreckende Verstellwelle (102, 104) vorgesehen ist, die derart mit wenigstens einem Aufnahmeteil (76 bis 81) gekoppelt ist, dass das Aufnahmeteil (76 bis 81) durch Verdrehen der Verstellwelle (102, 104) in Querrichtung verlagerbar ist.

9. Transporteinheit (50) nach einem der vorhergehenden Ansprüche, **dadurch gekennzeichnet, dass** zwei Rand-Aufnahmeteile (76,78 und 79,81) zur Aufnahme von jeweils einem Rand-Antriebsteil (86,88 und 89,91) vorgesehen ist, wobei die Antriebsrollen (96) des einen Rand-Antriebteils (86,88 und 89,91) den Antriebsrollen (96) des anderen Rand-Antriebteils (86,88 und 89,91) zugewandt und so angeordnet sind, dass im Betrieb der Transporteinheit (50) die Leiterplatte im Bereich ihrer freien Längskanten auf den jeweiligen Antriebsrollen (96) aufliegt.

10. Transporteinheit (50) nach Anspruch 9, **dadurch gekennzeichnet, dass** an den Rand-Antriebsteilen (86,88 und 89,91) Längsführungen (116) zur Führung der Leiterplatten in Transportrichtung (18) vorgesehen sind.

11. Transporteinheit (50) nach Anspruch 9 oder 10, **dadurch gekennzeichnet, dass** zwischen den Rand-Aufnahmeteilen (76,78 und 79,81) wenigstens ein Mitten-Aufnahmeteil (77,80) zur Aufnahme von einem Mitten-Antriebteil (87,90) vorgesehen ist.

12. Transporteinheit (50) nach Anspruch 11, **dadurch gekennzeichnet, dass** die Transporteinheit (50) zwei in Transportrichtung verlaufende Transportspuren (60) aufweist, wobei für jede Transportspur (60) jeweils zwei Rand-Aufnahmeteile (76,78 und 79,81) und/oder jeweils ein Mitten-Aufnahmeteil (77,80) vorgesehen ist.

13. Lötanlage (10), insbesondere Reflowlötanlage, zum Durchlauflöten von Leiterplatten in einem Prozesskanal (16) entlang einer Transportrichtung (18), wobei im Prozesskanal (16) wenigstens eine Vorheizzone (20), wenigstens eine Lötzone (22) und wenigstens eine Kühlzone (24) vorgesehen sind, wobei in der Lötzone eine Druckkammer (40) vorgesehen ist, die ein Basisteil (42) und ein gegenüber dem Basisteil (42), im Betrieb der Reflowlötanlage (10) anhebbares Deckelteil aufweist, **dadurch gekennzeichnet, dass** wenigstens in einer der Zonen (20, 22, 24) und/oder in der Druckkammer (40) eine Transporteinheit (50) nach einem der vorhergehenden Ansprüche vorgesehen ist.

## Claims

1. A transport unit (50) for transporting printed circuit boards along a transport direction (18) within at least one zone of a soldering system (10), in particular a reflow soldering system, a base part (68) being provided with a drivable output shaft (72), **characterized in that** at least two output gears (94) rotatably coupled to the output shaft (72) are provided, **in that** at least two drive parts (86 to 91) which can be releasably attached to and removed from the base part (68) are each provided with a drive gear (92) such that the drive parts (86 to 91) have drive rollers (96) which are rotatably coupled to the drive gear (92) and act against the printed circuit board to transport the printed circuit board through the zone, **in that** when the drive parts (86 to 91) are attached to the base part (68), each output gear (94) is in engagement with the associated drive gear (92), and **in that** receiving parts (76 to 81) extending in the direction of transport (18) on the base part (68) are provided for receiving and releasably attaching the drive parts (86 to 91), the receiving parts (76 to 81) each having the output gear (94) which can be brought into engagement with the drive gear (92) and can be driven by the output shaft (72).

2. The transport unit (50) according to claim 1, **characterized in that** the drive parts (86 to 91) have a plurality of drive rollers (96) arranged one behind the other in the direction of transport (18), adjacent drive rollers (96) being rotatably coupled to one another via gears (98), and at least one gear (98) being rotatably coupled to the drive gear (92).

3. The transport unit (50) according to claim 1 or 2, **characterized in that** the base part (68) is designed in the manner of a frame, with two side parts (68) extending in the direction of transport (18), and with two struts (70) extending in the transverse direction, running transverse to the direction of transport (18).

4. The transport unit (50) according to claim 3, **characterized in that** the arrangement is such that the frame can be releasably and removably arranged in the soldering system (10).

5. The transport unit (50) according to claim 3 or 4, **characterized in that** the output shaft (72) extends in the transverse direction and is arranged in a rotatably mounted manner on the two side parts.

6. The transport unit (50) according to claim 3, **characterized in that** at least one receiving part (76 to 81) is arranged in a manner allowing movement and adjustment on the struts (70) in the transverse direction.

7. The transport unit (50) according to claim 6, **characterized in that** the receiving parts (76 to 81) each provide a coupling gear (108) which is rotatably coupled to the output gear (94) and to the output shaft (72) and is arranged on the output shaft (72) in a manner allowing axial displacement.

8. The transport unit (50) according to claim 6 or 7, **characterized in that** at least one adjusting shaft (102, 104) is provided, which extends in the transverse direction and is coupled to at least one receiving part (76 to 81) in such a manner that the receiving part (76 to 81) can be displaced in the transverse direction by rotation of the adjusting shaft (102, 104).

9. The transport unit (50) according to any of the preceding claims, **characterized in that** two edge receiving parts (76, 78 and 79, 81) are provided for each receiving one edge drive part (86, 88 and 89, 91), the drive rollers (96) of one edge drive part (86, 88 and 89, 91) facing the drive rollers (96) of the other edge drive part (86, 88 and 89, 91) and being arranged in such a manner that, when the transport unit (50) is in operation, the printed circuit board rests, in the region of its free longitudinal edges, on the drive rollers (96).

10. The transport unit (50) according to claim 9, **characterized in that** longitudinal guides (116) for guiding the printed circuit boards in the direction of transport (18) are provided on the edge drive parts (86, 88 and 89, 91).

11. The transport unit (50) according to claim 9 or 10, **characterized in that** at least one center receiving part (77, 80) for receiving a center drive part (87, 90) is provided between the edge receiving parts (76, 78 and 79, 81).

12. The transport unit (50) according to claim 11, **characterized in that** the transport unit (50) has two transport tracks (60) extending in the direction of transport, two edge receiving parts (76, 78 and 79, 81) and/or one center receiving part (77, 80) being provided for each transport track (60).

13. A soldering system (10), in particular a reflow soldering system, for continuous soldering of printed circuit boards in a process channel (16) along a direction of transport (18), at least one preheating zone (20), at least one soldering zone (22), and at least one cooling zone (24) being provided in the process channel (16), a pressure chamber (40) being provided in the soldering zone, which chamber has a base part (42) and a cover part which can be lifted relative to the base part (42) during operation of the reflow soldering system (10), **characterized in that** a transport unit (50) according to any of the preceding claims is provided at least in one of the zones (20, 22, 24) and/or in the pressure chamber (40).

## Revendications

1. Unité de transport (50) pour transporter des cartes de circuits imprimés le long d'une direction de transport (18) à l'intérieur d'au moins une zone d'une installation de brasage (10), en particulier d'une installation de brasage par refusion, dans laquelle une partie de base (68) est pourvue d'un arbre de sortie (72) pouvant être entraîné, **caractérisée en ce qu'**au moins deux roues dentées menées (94) accouplées en rotation à l'arbre de sortie (72) sont prévues, qu'au moins deux parties d'entraînement (86 à 91) pouvant être fixées de manière détachable sur la partie de base (68) et pouvant être retirées sont pourvues de respectivement une roue dentée motrice (92), de telle sorte que les parties d'entraînement (86 à 91) présentent des rouleaux d'entraînement (96) accouplés en rotation à la roue dentée motrice (92), qui agissent pour transporter la carte de circuits imprimés à travers la zone contre la carte de circuits imprimés, que lorsque les parties d'entraînement (86 à 91) sont fixées sur la partie de base (68) la roue dentée menée (94) respective est en prise avec la roue dentée motrice (92) associée, et que des parties de réception (76 à 81) s'étendant dans la direction de transport (18) pour la réception et pour la fixation libérable des parties d'entraînement (86 à 91) sont prévues sur la partie de base (68), dans laquelle les parties de réception (76 à 81) présentent respectivement la roue dentée menée (94) pouvant être amenée en prise avec la roue dentée motrice (92) et pouvant être entraînée par l'arbre de sortie (72).

2. Unité de transport (50) selon la revendication 1, **caractérisée en ce que** les parties d'entraînement (86 à 91) présentent une pluralité de rouleaux d'entraînement (96) disposés les uns derrière les autres dans la direction de transport (18), dans laquelle des rouleaux d'entraînement (96) respectivement voisins sont accouplés en rotation les uns aux autres par l'intermédiaire de roues dentées (98) et dans laquelle au moins une roue dentée (98) est accouplée en rotation à la roue dentée motrice (92).

3. Unité de transport (50) selon la revendication 1 ou 2, **caractérisée en ce que** la partie de base (68) est réalisée côté cadre avec deux parties latérales (68) s'étendant dans la direction de transport (18) et avec deux longerons (70) s'étendant dans la direction transversale s'étendant transversalement par rapport à la direction de transport (18).

4. Unité de transport (50) selon la revendication 3, **caractérisée en ce que** l'agencement est disposé de telle sorte que le cadre peut être disposé dans l'installation de brasage (10) de manière détachable et amovible.

5. Unité de transport (50) selon la revendication 3 ou 4, **caractérisée en ce que** l'arbre de sortie (72) s'étend dans la direction transversale et est disposé de manière montée en rotation sur les deux parties latérales.

6. Unité de transport (50) selon la revendication 3, **caractérisée en ce qu'**au moins une partie de réception (76 à 81) est disposée de manière mobile et déplaçable dans la direction transversale sur les longerons (70).

7. Unité de transport (50) selon la revendication 6, **caractérisée en ce que** les parties de réception (76 à 81) prévoient respectivement une roue dentée d'accouplement (108), qui est accouplée en rotation à la roue dentée menée (94) et à l'arbre de sortie (72) et est disposée de manière à pouvoir coulisser axialement sur l'arbre de sortie (72).

8. Unité de transport (50) selon la revendication 6 ou 7, **caractérisée en ce qu'**au moins un arbre de déplacement (102, 104) s'étendant dans la direction transversale est prévu, qui est accouplé à au moins une partie de réception (76 à 81) de telle sorte que la partie de réception (76 à 81) peut être déplacée dans la direction transversale par rotation de l'arbre de déplacement (102, 104).

9. Unité de transport (50) selon l'une quelconque des revendications précédentes, **caractérisée en ce que** deux parties de réception de bord (76, 78 et 79, 81) pour la réception de respectivement une partie d'entraînement de bord (86, 88 et 89, 91) est prévue, dans laquelle les rouleaux d'entraînement (96) de la une partie d'entraînement de bord (86, 88 et 89, 91) sont tournés vers les rouleaux d'entraînement (96) de l'autre partie d'entraînement de bord (86, 88 et 89, 91) et sont disposés de sorte que lors du fonctionnement de l'unité de transport (50) la carte de circuits imprimés repose dans la zone de ses bords longitudinaux libres sur les rouleaux d'entraînement (96) respectifs.

10. Unité de transport (50) selon la revendication 9, **caractérisée en ce que** des guidages longitudinaux (116) pour le guidage des cartes de circuits imprimés dans la direction de transport (18) sont prévus sur les parties d'entraînement de bord (86, 88 et 89, 91).

11. Unité de transport (50) selon la revendication 9 ou 10, **caractérisée en ce qu'**au moins une partie de réception centrale (77, 80) pour la réception d'une partie d'entraînement centrale (87, 90) est prévue entre les parties de réception de bord (76, 78 et 79, 81).

12. Unité de transport (50) selon la revendication 11, **caractérisée en ce que** l'unité de transport (50) présente deux voies de transport (60) s'étendant dans la direction de transport, dans lesquelles respectivement deux parties de réception de bord (76, 78 et 79, 81) et/ou respectivement une partie de réception centrale (77, 80) est prévue pour chaque voie de transport (60).

13. Installation de brasage (10), en particulier installation de brasage par refusion, pour le brasage continu de cartes de circuits imprimés dans un canal de traitement (16) le long d'une direction de transport (18), dans laquelle au moins une zone de préchauffage (20), au moins une zone de brasage (22) et au moins une zone de refroidissement (24) sont prévues dans le canal de traitement (16), dans laquelle une chambre de pression (40), qui présente une partie de base (42) et une partie de couvercle pouvant être soulevée par rapport à la partie de base (42) lors du fonctionnement de l'installation de brasage par refusion (10), est prévue dans la zone de brasage, **caractérisée en ce qu'**une unité de transport (50) selon l'une quelconque des revendications précédentes est prévue au moins dans une des zones (20, 22, 24) et/ou dans la chambre de pression (40).
